**Europäisches Patentamt**

**European Patent Office**

**Office européen des brevets**

(19)

(11) Publication number : **0 442 536 B1**

(12) # EUROPEAN PATENT SPECIFICATION

(45) Date of publication of patent specification :
**17.08.94 Bulletin 94/33**

(51) Int. Cl.[5] : **G01B 11/30,** G01B 7/34,
G11B 11/08

(21) Application number : **91105520.0**

(22) Date of filing : **12.05.87**

(54) Atomic force sensor head for measuring the properties of a data store.

(43) Date of publication of application :
**21.08.91 Bulletin 91/34**

(45) Publication of the grant of the patent :
**17.08.94 Bulletin 94/33**

(84) Designated Contracting States :
**CH DE FR GB LI**

(56) References cited :
**GB-A- 2 150 304
US-A- 4 575 822
PHYSICA, vol. 24, 1958, pages 751-764, Amsterdam, NL; M.J. SPARNAAY:
"Measurements of attractive forces between flat plates"
PHYSICAL REVIEW LETTERS, vol. 56, no. 9, 3rd March 1986, pages 930-933, New York, US; G. BINNIG et al.: "Atomic force microscope"
JOURNAL OF APPLIED PHYSICS, vol. 57, no. 5, 1st March 1985, pages 1437-1444, American Institute of Physics, New York, US; J.R. MATEY et al.: "Scanning capacitance microscopy"**

(60) Publication number of the earlier application in accordance with Art. 76 EPC : **0 290 648**

(73) Proprietor : **International Business Machines Corporation
Old Orchard Road
Armonk, N.Y. 10504 (US)**

(72) Inventor : **Dürig, Urs Theodor, Dr.
Alte Landstrasse 89
CH-8803 Rüschlikon (CH)**
Inventor : **Rohrer, Heinrich, Dr.
Bachtelstrasse 27
CH-8805 Richterswil (CH)**
Inventor : **Binnig, Gerd Karl, Prof. Dr.
Bergstrasse 10c
W-8084 Inning (DE)**

(74) Representative : **Barth, Carl Otto et al
IBM Corporation
Zurich Intellectual Property Dept.
Säumerstrasse 4
CH-8803 Rüschlikon (CH)**

EP 0 442 536 B1

## Description

This invention relates generally to Atomic Force Microscopes (AFM) and more particularly to means for measuring the properties of a data store by means of an atomic force sensor head.

The Atomic Force Microscope proposed by G. Binnig in EP-A-0 223 918 and described by G. Binnig, C.F. Quate and Ch. Gerber, Phys. Rev. Letters, Vol.56, No.9, March 1986, pp.930-933, employs a sharply pointed tip attached to a spring-like cantilever beam to scan the profile of a surface to be investigated. At the distances involved, minute forces occur between the atoms at the apex of the tip and those at the surface, resulting in a tiny deflection of the cantilever. In Binnig's proposal, this deflection is measured by means of a tunneling microscope, i.e., an electrically conductive tunnel tip is placed within tunnel distance from the back of the cantilever beam, and the variations of the tunneling current are used to determine the deflection. With known characteristics of the cantilever beam, the forces occurring between the AFM tip and the surface under investigation can be determined.

The forces occurring between a pointed tip and a surface are usually described as van-der-Waals, covalent, ionic, or repulsive core interaction forces. The energies involved in the atomic distance approach between single atoms respectively at the apex of the tip and on a surface are in the range of $E_0 = 0,01...10eV = 10^{-22}...10^{-18}$ Joule. The corresponding distances are in the subnanometer range of $x_0 = 10...1000$ pm $= 0,01...1$ nm. The respective forces (i.e. the first derivatives of the potential function, therefore, are in the range of $K_0 = 10$ pN ... 10 nN. The resulting atomic 'spring constants', i.e., the second derivatives of the potential function are in the range of $C_0 = 100...0,01$ N/m. These data can be deduced from surface studies and many other sources, such as the values of elastic constants.

Experiments with van-der-Waals forces are reported in M.J. Sparnaay, "Measurements of Attractive Forces Between Flat Plates", Physica XXIV (1958) pp. 751-764. Fig. 2 of this reference shows a setup comprising a cantilever beam fixed at one end and bearing at half-length one plate of a pair of parallel plates, the other plate of which is mounted independent of the cantilever beam. The weight of the beam is balanced by a spring, and the deflection the beam undergoes upon interaction of the pair of plates is determined by the variation of a capacitor having one of its plates attached to the cantilever beam, while the other plate is fixed.

It is one object of the present invention to describe several embodiments of data stores which employ an atomic force measuring device which uses techniques alternative to tunneling, while keeping the cantilever as a force/deflection translator. The devices in accordance with the invention can be used as atomic force microscopes, but they may also find a wider field of application once available.

The present invention accordingly contemplates to teach an atomic force sensor head for measuring the prperties of a data storage medium, the sensor head being of the type having at least one cantilever beam fixed at one end and carrying an interaction member in a location distant from said fixed end for interaction with the surface of said storage medium to be investigated, and means for detecting the deflection of said cantilever beam as said interaction member interacts with said surface of the storage medium, wherein said detection means are designed to convert the deflection of said cantilever beam into a variation of an electrical value, other than a tunneling current, from an initial level thereof. This atomic force sensor head is characterized in that said detection means is designed as a capacitor comprising a pair of capacitor plates of which a first one forms an integral part with said cantilever beam while the second plate is mounted stationary opposite said first plate, that both plates of said capacitor are connected to conventional capacitance measurement equipment, and that the output signal of said capacitance measurement equipment, representing a variation of the capacitance of said capacitor from an initial capacitance value, is supplied via a feedback control circuit to a z-drive arranged for adjusting the z-distance of said interaction member from the surface of the storage medium.

Details of several embodiments of the invention will be described by way of example in the following description and with reference to the attached drawings in which:

Fig. 1      is a schematic diagram of an atomic force microscope using a capacitor as the deflection detector;

Fig. 2      shows a micromechanical embodiment of the capacitive force sensing head;

Fig. 3      shows an extension of the embodiment of Fig. 2, employing a piezoelectric transducer;

Fig. 4      shows another extension of the embodiment of Fig. 2 with a high-dielectric-constant material;

Fig. 5      shows a capacitive sensor head in a data storage application;

Fig. 6      shows another embodiment of a capacitive sensor head in a data storage application;

Fig. 7      shows a third embodiment of a capacitive sensor head in a data storage application;

Fig. 8      schematically explains surface softening measures in connection with the sensor head of Fig. 6.

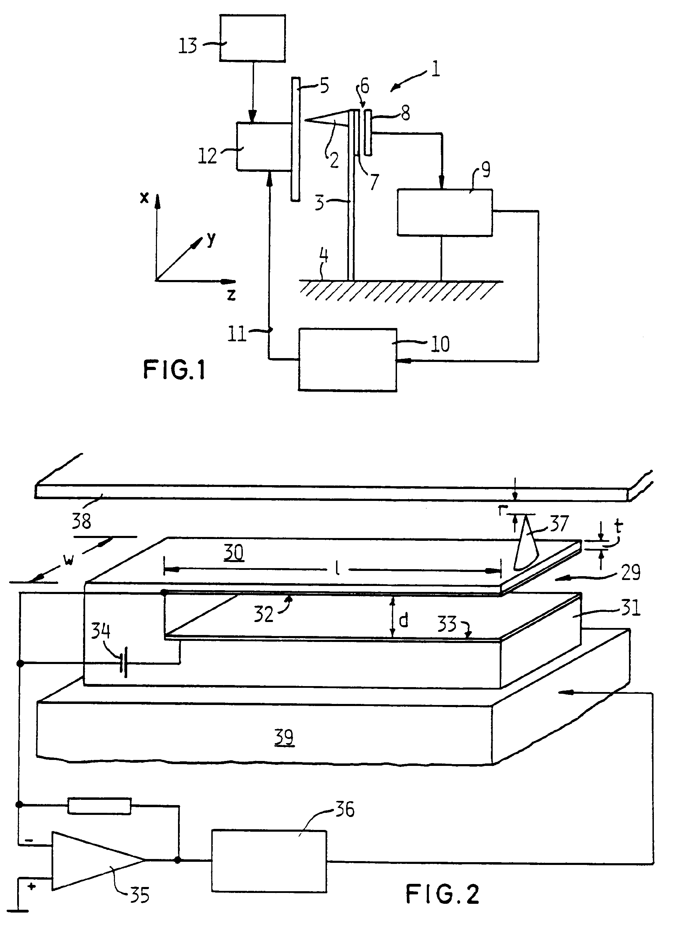

Referring to Fig. 1, there is shown an atomic force microscope 1 comprising a sharply pointed tip 2, which may, for example, consist of diamond, and which is attached to a cantilever beam 3 that rests on a base plate 4. As a sample 5 to be investigated is approached to tip 2, the forces occurring between the closest atoms at tip 2 and sample 5 will cause a deflection of cantilever beam 3. Assuming the said forces are repulsive, as they normally are, cantilever beam 3 will be deflected toward the right in Fig. 1. The amount of deflection is on the order of $10^{-11}$ m.

At its top, where the deflection is greatest, cantilever beam 3 forms one plate of a capacitor 6. For this purpose, cantilever beam 3 may either be made of an electrically conductive material, or carry a conductive coating at its upper end. The second plate 8 of capacitor 6 is arranged opposite coating 7/cantilever beam 3 at a very small distance. In Fig. 1, cantilever beam 3 is connected to ground, and capacitor plate 8 is connected to a conventional capacitance measurement device 9, which may be, for example, an AC Wheatstone bridge.

At rest, the capacitance meter 9 is adjusted such that its output is zero. As cantilever beam 3 is deflected under the influence of a force exerted on its tip 2, the capacitance is varied, and an output signal is generated from capacitance meter 9. This output signal is used by a feedback circuit 10 to generate a control signal on line 11 which is fed to the z-part of an xyz-drive 12. This z-part is responsible for controlling the distance between the surface of sample 5 and the apex of tip 2. (The x- and y-parts of xyz-drive 12 control the matrix-scanning of tip 2 across the surface of sample 5 under the direction of an xy-control unit 13.)

State-of-the-art capacitance meters can measure capacitance changes as small as $\Delta C = 10^{-18}$ F (attofarad), using techniques as described, for instance, by J.R. Matey and J. Blanc, J.Appl. Phys., 57, p. 1437 (1985). This sensitivity can be employed to measure changes in distance or dielectric constant in accordance with the parallel plate capacitor formula $C = \varepsilon A/d$, where $\varepsilon$ is the dielectric constant, A is the plate area, and d is the plate separation. For a plate area of 100 by 100 micrometers and a plate separation of 1 micrometer, in air a capacitance of about $2 \cdot 10^{-13}$ F results. The sensitivity mentioned above hence translates into a minimum detectable gap width variation of $\Delta d = (d/C) \cdot \Delta C = 10^{-11}$ m.

Fig. 2 shows an embodiment of the force sensing head in which the tip-carrying cantilever beam 30 is arranged opposite a rigid body 31 acting as a solid base. Preferably, cantilever beam 30 and body 31 are manufactured from one piece of $Si/SiO_2$ by well known micromechanical techniques. The mutually facing surfaces of cantilever beam 30 and body 31 are respectively coated with thin gold layers 32 and 33, thus forming a capacitor 29, to which a voltage source 34 is connected. The gold layer 32 of cantilever beam 30 is also connected to an amplifier 35. The output terminal of the latter is connected to a discriminator 36.

As the tip 37 is approached to the surface of the sample 38, the nearmost atoms at tip and surface interact, developing a force between them which is determined by their interaction potential $U_{int}$, their distance r, and the spring constant C of cantilever beam 30. In equilibrium, i.e., when the atomic force $dU_{int}/dr$ balances the spring force C x, the deflection of cantilever beam 30 is given by:

$$U_{int} + \frac{1}{2} C x^2 = \text{Min.}$$

The embodiment of Fig. 2 may be adjusted to yield a static deflection $x \simeq 10 \ldots 100$ pm which can be detected statically. Cantilever beam 30 also is a harmonic oscillator with an eigenfrequency $\omega_0$. In the presence of the said atomic interaction, the resonance frequency of cantilever beam 30 is shifted in accordance with

$$\omega^2 = \omega_0^2 \left( 1 + \frac{1}{C} \frac{d^2 U_{int}}{dr^2} \right).$$

This term assumes that higher-order terms of the interaction potential do not contribute to the equation of motion. The measurement of the frequency shift has the great advantage of eliminating the length measurement, resulting in simplified calibration of the sensor head.

The design of this sensor head has to be optimized with regard to opposing requirements: For the sake of high sensitivity, a weak spring constant C is desirable. However, the maximum tolerable amplitude of the thermal vibrations of the arrangement poses a lower limit. Furthermore, C should be larger than the maximum of $d^2U_{int}/dr^2$, lest metastable equilibrium positions would exist, rendering reliable operation of the sensor head impossible. This might become a severe problem in the case of the short-range covalent binding interaction where second derivatives of the potential of the order of 10...100 N/m are to be expected. Accordingly, a rather stiff cantilever beam is desirable.

The micromechanical cantilever beam 30 in accordance with the present invention provides an optimum performance. Its resonance frequency is monitored by measuring the capacitive current which is introduced by thermal vibrations on the beam. In a feedback loop, the natural vibration amplitude of the beam can be increased to thereby enhance the sensitivity of the sensor head. This provides a convenient way to adapt the properties of the sensor head to the particular form of the interaction potential. For example, at large tip/sample distance, where the interaction is weak, the required high sensitivity is achieved by increasing the vibration amplitude to about one nanometer. As the interaction becomes stronger upon the tip approaching the surface, the beam vibration can be decreased to avoid touch-down to the surface.

Referring again to Fig. 2, oscillations of cantilever beam 30 cause capacitance variations which give rise to a corresponding AC current. This current is amplified by an amplifier 35, and the frequency of the oscillations is measured by standard techniques. Body 31 may be mounted on a conventional xyz-drive (not shown) for approaching tip 37 to the surface of sample 38, and for scanning the tip across that surface.

To permit detailed investigation of the weak attractive forces between two atoms, i.e., the second derivative of the interaction potential $C_{int} = d^2 U_{int}/dr^2$, the embodiment of Fig. 2 should be dimensioned in accordance with the following considerations:

The second derivative $C_{int}$ of the interaction potential $U_{int}$ and the measured frequency shift $\Delta\omega$ are related as follows:

$$C_{int} = 2\ C_{eff}\ \frac{\Delta\omega}{\omega_0},$$

where $C_{eff}$ is approximately equal to the static spring constant of cantilever beam 30. The detection threshold $C_{min}$ can be expressed in terms of the eigenfrequency $\omega_0$, the Q factor of the resonator, and the integration time $\tau$ of the frequency measurement:

$$C_{min}\ =\ 2\ \frac{C_{eff}}{\sqrt{Q\omega_0\tau}}.$$

$C_{min}$ is chosen at 0.01 N/m; a Q factor of 1000 for a micromechanical cantilever beam has recently been established; the integration time $\tau$ must not exceed 10 ms in order to allow for constant force scanning microscopy in addition to the measurement of the interaction potential $U_{int}$; and the eigenfrequency $\omega_0$ should be about $2\pi \times 10kHz$ in order to allow adequate isolation from ambient vibrations. With these parameters, one obtains $C_{eff} = 4$ N/m and a detector sensitivity of 1,25 kHz/(N/m). In other words, a $C_{min}$ of 0,01 N/m gives rise to a frequency shift of 12,5 Hz. The rms amplitude of the thermal vibrations is 0,016 nm at liquid nitrogen temperature and 0,03 nm at room temperature.

Terms of the interaction potential $U_{int}$ of an order greater than 3 give rise to an additional frequency shift proportional to the square of the vibration amplitude. This frequency shift causes an ambiguity $C_{ah}$ of the measured $C_{int}$ of the order of

$$C_{ah} < \frac{1}{8}\left|\ \frac{d^4 U_{int}}{dr^4}\ \right| x_{th}^2.$$

Considering the fact that $C_{eff} = K \cdot f_R$, with K being a constant close to unity, the dimensions for cantilever 30 can be calculated from the following equations for the force constant $f_R$ and for the resonant frequency $\omega_0$:

$$f_R\ =\ \frac{1}{4}\ E\ \frac{w\ t^3}{l^3}$$

$$\omega_0\ =\ 1,02\left(\frac{E}{\rho}\right)^{\frac{1}{2}}\frac{t}{l^2},$$

wherein $E = 7,2 \times 10^{10}$ N/m² is Young's modulus of elasticity for $SiO_2$, w, t and l are respectively width, thickness and length of cantilever 30, and $\rho = 2,2 \times 10^3$ kg/m³ is the specific density of the cantilever material. With the parameters indicated above and with the realistic assumption that w should equal 8t, the dimensions of the cantilever beam result as w = 115µm, t = 14µm, and l = 1150µm.

Choosing a spacing d of 10 µm between gold layers 32 and 33, the capacitance becomes $C_b = 0,12pf$. The induced AC current I is:

$$I\ =\ V\ \frac{dC_b}{dt}\ =\ 0,392\ C_b\omega_0 x_{th}\ \frac{V}{d}.$$

With a potential V = 50V, one obtains a rms current of 0,25 pA. Currents of this order of magnitude can be detected with conventional FET amplifiers.

The electric field existing between gold electrodes 32 and 33 exerts an additional force on the cantilever beam, increasing its $C_{eff}$ by a factor k

$$k\ =\ \sqrt{1\ +\ C_b\ \frac{V^2}{m\omega_0^2 d^2}}\ ,$$

wherein m is the mass of cantilever beam 30. In this particular example, the factor $k \approx 1,1$.

An important extension of the embodiment of Fig. 2 is the incorporation of feedback to increase the natural vibration amplitude of the cantilever beam. This will enhance the sensitivity of the sensor head and open further fields of applicability.

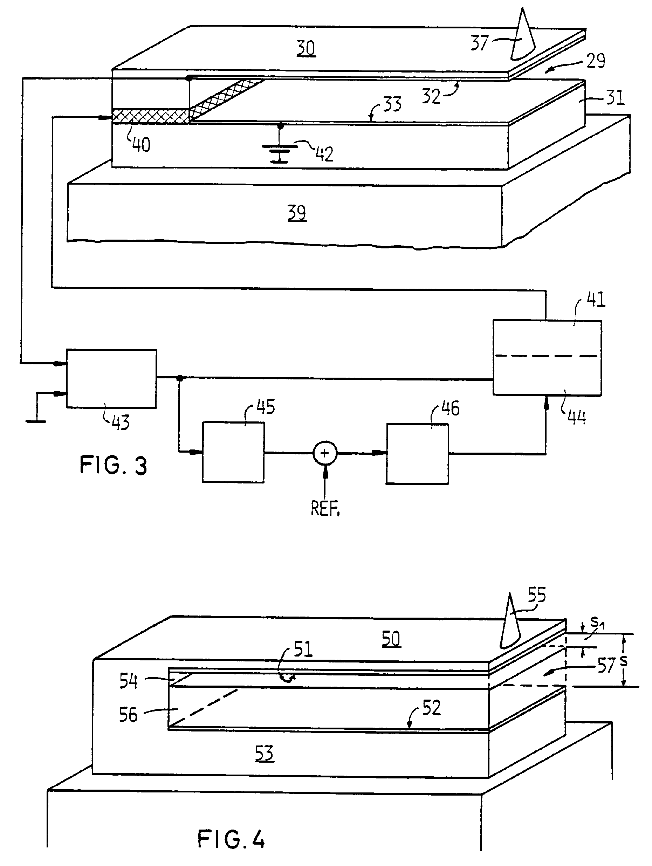

Fig. 3 shows one way of implementing a feedback loop in a micromechanical sensor head. The same as in the embodiment of Fig. 2, cantilever beam 30 carries an electrode 32 and is arranged opposite body 31 which carries its electrode 33. Cantilever beam 30 is mounted on top of a piezoelectric transducer 40 which rests on body 31. Transducer 40 can be excited by the output signal from an excitation unit 41. A voltage source 42 is connected between electrode 33 and ground, and electrode 32 is connected to the input terminal of an I/V converter 43. The output signal of the latter controls a fast-controllable gain amplifier 44 and, via rectifier 45 and with the addition of a fluctuation amplitude reference signal, a slow-controllable feedback amplifier 46 which supplies a gain control signal to gain amplifier 44.

Fig. 4 shows a modification of the embodiments described in connection with Figs. 2 and 3. An insulating layer 56 with high dielectric constant fills part of the gap between the electrodes 51 and 52. This has a threefold beneficial effect:

- The electrodes cannot touch one another and cause a shortcircuit.
- The deflection of the cantilever beam is stable within the remaining free gap 54 between the electrodes.
- The sensitivity is enhanced if the dimensions are chosen appropriately.

The arrangement of Fig. 4 is essentially the same as described before, with the exception that the gap between electrode 51 carried by cantilever 50 and counterelectrode 52 resting on body 53 is filled with two (or more) dielectric materials having different dielectric constants $\varepsilon_r$. Preferably, the dielectric material 54 arranged next to cantilever beam 50 should be extremely flexible, so as not to impair the movements of the cantilever beam 50 caused by the tip 55 coming close to the surface to be investigated. The obvious material is air having a dielectric constant $\varepsilon_1 = 1$.

The other dielectric material 56 being disposed away from cantilever beam 50 should have a dielectric constant $\varepsilon_2$ much higher than that of the dielectric material 54, say by a factor of 10.

The arrangement of Fig. 4 actually constitutes a series connection of two capacitors with a total capacitance C of:

$$C = \frac{\varepsilon_0\, A}{s}\ \frac{\varepsilon_2}{1 + \dfrac{s_1}{s}\left(\dfrac{\varepsilon_2}{\varepsilon_1} - 1\right)} = \frac{\varepsilon_0\, A}{s}\ \frac{\varepsilon_2}{B}\,,$$

wherein A is the area of the capacitor and B is indicative of the interrelation of the relative thicknesses and dielectric constants of the dielectric materials 54 and 56:

$$B = 1 + \frac{s_1}{s}\left(\frac{\varepsilon_2}{\varepsilon_1} - 1\right).$$

To determine the improvement in sensitivity, the foregoing term for C is differentiated:

$$\frac{dC}{ds_1} = -\frac{\varepsilon_0\, A}{s^2}\left(\frac{\varepsilon_2^2}{\varepsilon_1} - \varepsilon_2\right)\frac{1}{B^2}.$$

With a relationship $\dfrac{s_1}{s} = 0,05$ and a 1:10 relation for the dielectric constants, the sensitivity improvement by filling part of the gap s becomes:

$$F = \frac{\varepsilon_2^{\,2}}{B^2} = \frac{90}{2,1} \approx 40.$$

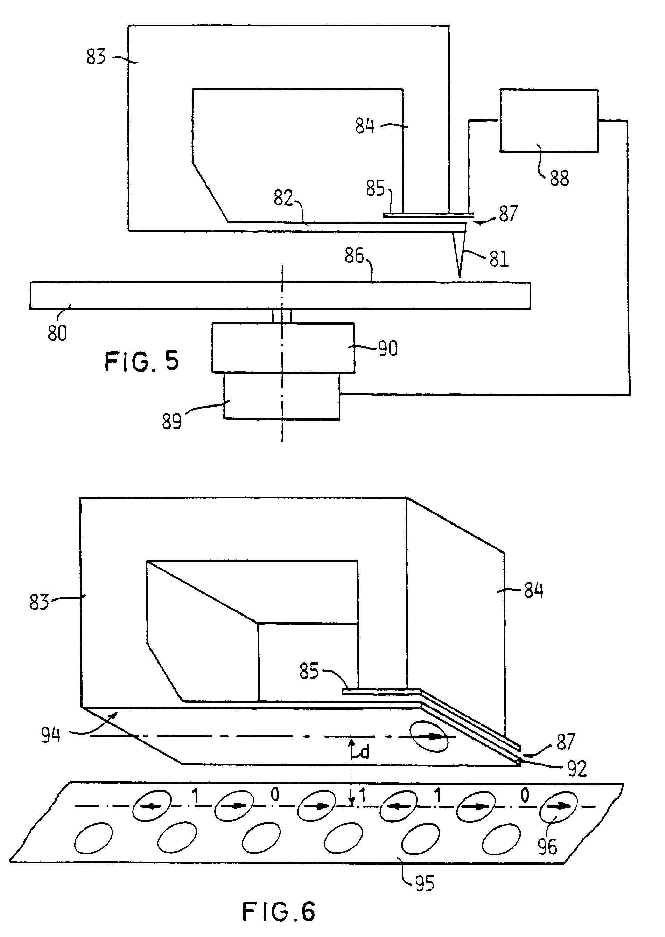

An application of the invention in a magnetic storage unit is shown schematically in Fig. 5. The place of the sample 5 of Fig. 1 is here taken by the magnetic storage medium 80 which is assumed to travel at high velocity past a tip 81 attached to a cantilever beam 82. The latter is mounted at a frame member 83 which is rigidly supported in the storage unit. Supported by an arm 84 of frame member 83 is a capacitor plate 85 which, together with the back of cantilever beam 82, forms a capacitor 87.

A variation of the force exerted on tip 81 caused either by a change of the distance between tip 81 and the surface of storage medium 80, or by a change of some surface property of storage medium 80 to which tip 81 is sensitive (such as magnetic field properties), causes a deflection of cantilever beam 82 from its original position. As a consequence, the capacitance of capacitor 87 is altered and, hence, a correction signal is developed by a distance control unit 88 for controlling a jack 89 which lowers or lifts the disk drive 90, in accordance with the sign of the force variation.

Another embodiment of a capacitive force sensor in connection with a magnetic data store is shown in Fig. 6. A cantilever beam 92 carries a little single-domain magnetic particle 93 on its side 94 facing the storage medium 95. The storage medium has a plurality of tracks along which magnetic domains 96 of one of two directions are disposed. A change in orientation between two domains adjacent along one track may be assigned to a stored "1", whereas no change between adjacent domains may be assigned to a stored "0". These changes of domain orientation can be detected by a single-domain magnetic particle attached to the cantilever beam, provided the flying hight is adjusted to be about 100 nanometers.

Each of said tracks of magnetic domains is stacked end to end, one particle wide and one particle thick. An assumed separation between neighboring tracks of five domain diameters would correspond to a recording density of about $6 \cdot 10^{11}$ bit/cm$^2$. The frequency response, and thus the data rate is limited by the mechanical response of cantilever beam 92, and this can be several MHz for a relativily small cantilever beam.

Assuming that cantilever beam 92 should have an eigenfrequency of several MHz: f/m = $\omega^2$ = $10^{14}$ s$^{-2}$. The frequency will be limited by thermal fluctuations. With a gap 87 of a width $x_c \sim 0.5$nm, and with the condition $f\, x_c^2 > kT$, and $kT \approx 2.5 \times 10^{-21}$ J at 300 K, $f > \dfrac{kT}{x_c^2} \sim 10^{-2}$ N/m.

The smallest force that can be measured with an eigenfrequency of several MHz with a cantilever beam of the mass m = f/$\omega^2$ = $10^{-16}$ kg in the presence of thermal fluctuations, under the assumption of a quality factor of the force sensor Q = 100, in a time $2\pi/\omega$ is

$$k \approx f \frac{x_c}{Q} \approx 5 \cdot 10^{-14} \text{N}.$$

Provided the magnetic field existing between particle 93 and the domains 96 on the magnetic medium 95 is sufficiently strong to cause a force of at least $10^{-14}$ N to be available to deflect cantilever beam 92, the arrangement of Fig. 6 can also be used to map with high spatial resolution the magnetic fields of a structure passing underneath cantilever beam 92.

The sizes of the magnetic forces available for measurement are estimated as follows: Single-domain magnetic particles of gamma iron oxide have a volume V of about $10^{-21}$ m$^3$ and a magnetization of about 400 G (= 0.4 T). Their magnetic moment will be M = $4 \cdot 10^{-19}$ G m$^3$. The magnetic force is given by:

$$F \;=\; MV \frac{\partial H}{\partial r}$$

With a field gradient $\dfrac{\partial H}{\partial r} = 10^{11}$ A/m$^2$, the force is F = $0,4 \cdot 10^{-10}$ N. This value is well within the sensitivity of the arrangement.

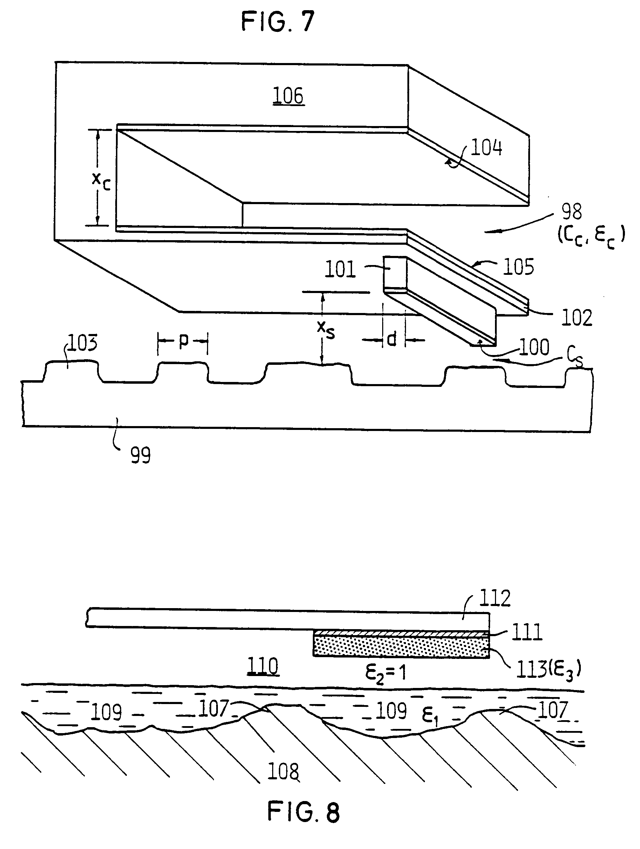

The arrangement shown in Figs. 5 and 6 can be somewhat extended to suit the purposes of a moving surface storage unit through replacement of the tip 81 (or the magnetic particle 93) by a capacitor plate 100, as shown in Fig. 7, and attaching the same to a member 101 which in turn is fixed on cantilever beam 102. (Note that the arrangement of Fig. 7 is shown upside down with respect to Figs. 5 and 6.) As the information represented by an information pattern 103, sitting on a record carrier 99, is passed underneath capacitor plate 100, the capacitance $C_s$ changes together with any variations of the distance $x_s$ between capacitor plate 100 and pattern 103. In view of the capacitive forces existing across the distance $x_s$ between plate 100 and information pattern 103, cantilever beam 102 will be deflected, and the capacitance $C_c$ of the capacitor formed by the conductive layers on the facing surfaces of cantilever beam 102 and body 106 will vary owing to the distance $x_c$ changing. The figure of merit, M, is the leverage obtained by measuring the position of cantilever beam 102:

$$M \;=\; \frac{\left( \dfrac{dC_c}{dx_s} \right)}{\left( \dfrac{dC_s}{dx_s} \right)} \,.$$

In the case of a soft cantilever beam, the main leverage is the capacitance ratio:

$$M_{soft} = \frac{C_c}{C_s} \frac{\dfrac{x_s}{\varepsilon_s}}{\dfrac{x_c}{\varepsilon_c}} \frac{B_s^2}{B_c^2},$$

wherein $\varepsilon_s$ and $\varepsilon_c$ are the dielectric constants of the media in capacitances $C_s$ and $C_c$, respectively, and $B_s$ and $B_c$ are constant values close to unity, characteristic of the capacitances whose indices they carry.

For a rigid cantilever beam, the leverage is the attenuation $\dfrac{1}{\alpha}$ of the effective spring constant $f_{eff}$ and the voltage ratio:

$$M_{rigid} = \frac{1}{\alpha} \frac{\dfrac{x_c}{\varepsilon_c}}{\dfrac{x_s}{\varepsilon_s}} \frac{B_c}{B_s} \frac{V_s^2}{V_c^2}$$

Choosing a simple example with the following parameters:

$C_s/C_c$ = ratio of areas = $10^2$ μm$^2$ / $10^5$ μm$^2$; $x_s = 0,1$ μm; $x_c = 1$ μm; $\varepsilon_s = 1$; $\varepsilon_c = 10$; $V_s = 5$ V; $V_c = 1$ V; $B_s \approx 1$; $B_c \approx 1$; $\alpha = 1/5$, yields:

$$M_{soft} \approx 10^3$$
$$M_{rigid} \approx 125.$$

A general problem with moving surface storage units is the existence of undesired corrugations on the surface which can have an unwanted effect on the writing or reading of information. The capacitive embodiment of the present invention offers a simple solution to the problem. Fig. 8 shows the principle. The surface corrugations 107 on storage medium 108 are covered by a dielectric medium 109 having a dielectric constant $\varepsilon_1$. Dielectric medium 109 may, for example, be a liquid. Separated from storage medium 108 by an air gap 110 ($\varepsilon_2 = 1$) is a capacitor plate 111 which is attached to a cantilever beam 112. Capacitor plate 111 carries a dielectic member 113 having a dielectric constant $\varepsilon_3$, serving to protect capacitor plate 111. The arrangement of Fig. 8 operates to 'demagnify' the surface roughness of storage medium 108. To regulate for constant capacitance, we have

$$ds_1 = -\frac{\varepsilon_1}{\varepsilon_2} ds_2,$$

i.e., capacitor plate 111 follows the contour of storage medium 108 with an attenuation of $\varepsilon_1/\varepsilon_2$.

Electrostatic attraction due to surface charges can be monitored in the same way as magnetic forces if the magnetic particle is replaced by a conducting (chargeable) tip. A charge of 40 electrons, for instance, creates a force of roughly 1 nN at a tip/sample gap of 30 nm. Assuming a typical surface charge density of 0,01 Cb/m$^2$ the 40 e charge can be accommodated in an area of 30x30 nm$^2$. Considering such a charged area as a storage bit and requiring a safety distance of 70 nm in each direction, one arrives at a storage scheme with a density of $10^{14}$ bit/m$^2$ which is far above present day's technology.

## Claims

1.  Atomic force sensor head for measuring the properties of a data storage medium (5, 38, 80, 95, 99, 108), comprising at least one cantilever beam (3, 30, 50, 70, 82, 92, 102, 112) fixed at one end and carrying an interaction member (2, 37, 55, 81, 93, 101, 113) in a location distant from said fixed end for interaction with the surface of said storage medium (5, 38, 80, 95, 99, 108) to be investigated, and means (6, 29, 98) for detecting the deflection of said cantilever beam (3, 30, 50, 82, 92, 102, 112) as said interaction member (2, 37, 55, 81, 93, 101, 113) interacts with said surface of the storage medium (5, 38, 80, 95, 99, 108), wherein said detection means (6, 29, 98) are designed to convert the deflection of said cantilever beam (3, 30, 50, 82, 92, 102, 112) into a variation of an electrical value, other than a tunneling current, from an initial level thereof, *characterized* in that said detection means is designed as a capacitor (6, 29, 57, 87) comprising a pair of capacitor plates (7, 8; 32, 33; 51, 52; 82, 85; 92, 85; 104, 105; 108, 111) of which a first one (7, 32, 51, 82, 92, 105, 111) forms an integral part with said cantilever beam (3, 30, 50, 82, 92, 102, 112) while the second plate (8, 33, 52, 85, 104, 108) is mounted stationary opposite said first plate (7, 32, 51, 82, 92, 105, 111) that both plates of said capacitor (6, 29, 57, 87) are connected to conventional capacitance measurement equipment, and that the output signal of said capacitance measurement equipment, representing a variation of the capacitance of said capacitor (6, 29, 57 87) from an initial capacitance value, is supplied via a feedback control circuit (10; 35, 36; 43-46: 88) to a z-drive (12, 39, 89) arranged for adjusting the z-distance of said interaction member (2, 37, 55, 81, 93, 101, 113) from the surface of the storage medium (5, 38, 80, 95, 99, 108).

2. Sensor head in accordance with claim 1, *characterized* in that said cantilever beam (92) is attached to a rigidly supported frame member (83) an arm (84) of which carries a capacitor plate (85) at its free end and opposite the back of said cantilever beam (92), said plate (85) and said cantilever beam (92) forming a capacitor (87), and that said cantilever beam (92) carries an interaction member designed as a magnetic element (93) attached to the lower side (94) of said cant lever beam (92) and facing at a predetermined short distance (d) a magnetic storage medium (95) carrying at least one track of magnetic domains (96).

3. Sensor head in accordance with claim 1, *characterized* in that said interaction member is designed as a dielectric member (101, Fig. 8) attached to the free end of said cantilever beam (102), that said dielectric member (101) carries an electrode (100) serving as a first plate of a capacitor ($C_s$) the other plate of which is formed by the information pattern (103) carried by said storage medium (99) in operation passing underneath said dielectric member (101).

4. Sensor head in accordance with claim 1, *characterized* in that said interaction member is designed as the first plate (111) of a capacitor and is attached to said cantilever beam (112) at the free end thereof, that said first capacitor plate (111) carries a dielectric member (113) having a first dielectric constant ($\varepsilon_3$), that said first capacitor plate (111) is separated by an air gap (110, $\varepsilon_2 = 1$) from said storage medium (108), the latter having an electrically conductive surface and forming the second plate of said capacitor, and that said storage medium (108) is coated with a soft dielectric medium (109, $\varepsilon_1$) smoothing out any possible corrugations (107) on said storage medium (108).

## Patentansprüche

1. Atomarer Kräftesensorkopf zum Messen der Eigenschaften eines Datenspeichermediums (5, 38, 80, 95, 99, 108), mindestens einen Freiträger (3, 30, 50, 70, 82, 92, 102, 112) umfassend, der an einem Ende befestigt ist und der in einem bestimmten Abstand von dem genannten festen Ende ein Interaktionselement (2, 37, 55, 81, 93, 101, 113) trägt, zur Interaktion mit der Oberfläche des genannten zu untersuchenden Speichermediums (5, 38, 80, 95, 99, 108), und Mittel (6, 29, 98) zum Erfassen der Auslenkung des genannten Freiträgers (3, 30, 50, 82, 92, 102, 112), wenn das genannte Interaktionselement (2, 37, 55, 81, 93, 101, 113) mit der genannten Oberfläche des Speichermediums (5, 38, 80, 95, 99, 108) in Wechselwirkung tritt, wobei die genannten Erfassungsmittel (6, 29, 98) so konstruiert sind, daß sie die Auslenkung des genannten Freiträgers (3, 30, 50, 82, 92, 102, 112) in eine Veränderung eines elektrischen Werts umwandeln, der kein Tunnelstrom ist, und zwar ausgehend von einem Ausgangswert desselben, dadurch gekennzeichnet, daß das genannte Erfassungsmittel als Kondensator (6, 29, 57, 87) ausgeführt ist, der ein Paar von Kondensatorblechen (7, 8; 32, 33; 51, 52; 82, 85; 92, 85; 104, 105; 108, 111) umfaßt, von denen eine erste (7, 32, 51, 82, 92, 105, 111) einen integrierten Teil des genannten Freiträgers (3, 30, 50, 82, 92, 102, 112) bildet, während die zweite Platte (8, 33, 52, 85, 104, 108) fest gegenüber der genannten ersten Platte (7, 32, 51, 82, 92, 105, 111) montiert ist, daß beide Platten des genannten Kondensators (6, 29, 57, 87) an herkömmliche Kapazitätsmeßausrüstungen angeschlossen sind, und daß das Ausgangssignal der genannten Kapazitätsmeßausrüstung, das eine Veränderung der Kapazität des genannten Kondensators (6, 29, 57, 87), ausgehend von einem Ausgangskapazitätswert, darstellt, über eine Rückkoppelungs-Steuerschaltung (10; 35, 36; 43-46; 88) an einen z-Antrieb (12, 39, 89) gesendet wird, der so angeordnet ist, daß er den z-Abstand des genannten Interaktionselements (2, 37, 55, 81, 93, 101, 113) zur Oberfläche des Speichermediums (5, 38, 80, 95, 99, 108) justiert.

2. Sensorkopf nach Anspruch 1, dadurch gekennzeichnet, daß der genannte Freiträger (92) an einem starr gelagerten Rahmenelement (83) angebracht ist, dessen Arm (84) eine Kondensatorplatte (85) an seinem freien Ende und gegenüber der Rückseite des genannten Freiträgers (92) trägt, wobei die genannte Platte (85) und der genannte Freiträger (92) einen Kondensator (87) bilden, und daß der genannte Freiträger (92) ein Interaktionselement trägt, das als ein magnetisches Element (93) ausgeführt ist, angebaut an der Unterseite (94) des genannten Freiträgers (92) und, in einem vorbestimmten geringen Abstand (d) einem magnetischen Speichermedium (95) gegenüberliegend, welches mindestens eine Spur von magnetischen Domänen (96) trägt.

3. Sensorkopf nach Anspruch 1, dadurch gekennzeichnet, daß das genannte Interaktionselement als dielektrisches Element (101, Fig. 8) ausgeführt ist, angebracht am freien Ende des genannten Freiträgers (102), daß das genannte dielektrische Element (101) eine Elektrode (100) trägt, die als erste Platte eines Kondensators ($C_s$) dient, dessen andere Platte von dem Informationsmuster (103) gebildet wird, welches von dem genannten Speichermedium (99) getragen wird, und welches im Betrieb unter dem genannten dielektrischen Element (101) hindurchläuft.

4. Sensorkopf nach Anspruch 1, dadurch gekennzeichnet, daß das genannte Interaktionselement als die erste Platte (111) eines Kondensators ausgeführt ist und an dem genannten Freiträger (112) an dessen freiem Ende angebracht ist, daß die genannte erste Kondensatorplatte (111) ein dielektrisches Element (113) trägt, mit einer ersten dielektrischen Konstante ( $\varepsilon_3$ ), daß die genannte erste Kondensatorplatte (111) durch einen Luftspalt (110, $\varepsilon_2 = 1$) von dem genannten Speichermedium (108) getrennt ist, wobei letzteres eine elektrisch leitfähige Oberfläche hat und die zweite Platte des genannten Kondensators bildet, und daß das genannte Speichermedium (108) mit einem weichen dielektrischen Medium (109, $\varepsilon_1$) beschichtet ist, welches mögliche Rillen (107) auf dem genannten Speichermedium (108) glättet.

## Revendications

1. Tête de détection de forces atomiques pour mesurer les propriétés d'un support d'informations (5, 38, 80, 95, 99, 108), comprenant au moins un porte-à-faux (3, 30, 50, 70, 82, 92, 102, 112) fixe en l'une de ses extrémités et portant un élément d'interaction (2, 37, 55, 81, 93, 101, 113) situé à une certaine distance de ladite extrémité fixe pour interagir avec la surface du dit support d'informations (5, 38, 80, 95, 99, 108) à inspecter, et des dispositifs (6, 29, 98) pour détecter la déflexion du dit porte-à-faux (3, 30, 50, 82, 92, 102, 112) lorsque ledit élément d'interaction (2, 37, 55, 81, 93, 101, 113) interagit avec la surface du dit support d'informations (5, 38, 80, 95, 99, 108), dans laquelle les dits dispositifs détecteurs (6, 29, 98) sont conçus pour convertir la déflexion du dit porte-à-faux (3, 30, 50, 82, 92, 102, 112) en une variation d'une valeur électrique, autre qu'un courant par effet de tunnel, à partir d'un niveau initial de celle ci, *caractérisée ence que* les dits dispositifs détecteurs sont conçus sous la forme d'un condensateur (6, 29, 57, 87) comprenant une paire d'armatures de condensateur (7, 8; 32, 33; 51, 52; 82, 85; 92, 85; 104, 105; 108, 111) dont la première (7, 32, 51, 82, 92, 105, 111) fait partie intégrante du dit porte-à-faux (3, 30, 50, 82, 92, 102, 112) tandis que la seconde armature (8, 33, 52, 85, 104, 108) est montée de manière fixe face à ladite première armature (7, 32, 51, 82, 92, 105, 111); les deux armatures du dit condensateur (6, 29, 57, 87) sont connectées à un dispositif conventionnel de mesure de capacité; et le signal de sortie du dit dispositif de mesure de capacité, représentant une variation de la capacité du dit condensateur (6, 29, 57, 87) par rapport à une valeur de capacité initiale, est transmis via une circuit asservi (10; 35, 36; 43-46; 88) à une commande-z (12, 39, 89) disposée pour régler la distance-z du dit élément d'interaction (2, 37, 55, 81, 93, 101, 113) par rapport à la surface du dit support d'informations (5, 38, 80, 95, 99, 108).

2. Tête de détection selon la revendication 1, *caractérisée en ce que* ledit porte-à-faux (92) est fixé à un élément de support soutenu rigidement (83) dont un bras (84) porte une armature de condensateur (85) sur son extrémité qui repose librement et qui fait face au dos du dit porte-à-faux (92), ladite armature (85) et ledit porte-à-faux (92) formant un condensateur (87); et en ce que ledit porte-à-faux (92) porte un élément d'interaction conçu sous la forme d'un élément magnétique (93) fixé sur la face inférieure (94) du dit porte-à-faux (92) et faisant face, à une courte distance prédéterminée (d), à un support d'informations (95) portant au moins une piste de domaines magnétiques (96).

3. Tête de détection selon la revendication 1, *caractérisée en ce que* ledit élément d'interaction est conçu sous la forme d'un élément diélectrique (101, Fig. 8) fixé sur l'extrémité libre du dit porte-à-faux (102); et en ce que ledit élément diélectrique (101) porte une électrode (100) constituant la première armature d'un condensateur ($C_s$) dont la seconde armature est constituée par le train d'informations (103) porté par ledit support d'informations (99) en exploitation, passant sous ledit élément diélectrique (101).

4. Tête de détection selon la revendication 1, *caractérisée en ce que* ledit élément d'interaction est conçu sous la forme de la première armature (111) d'un condensateur, et est fixé sur l'extrémité libre du dit porte-à-faux (112); ladite première armature de condensateur (111) porte un élément diélectrique (113) caractérisé par une première constante diélectrique ($\varepsilon_3$); ladite première armature de condensateur (111) est séparée par un entrefer (110, $\varepsilon_2 = 1$) du dit support d'informations (108), ce dernier ayant une surface électriquement conductrice et formant la seconde armature du dit condensateur; et ledit support d'informations (108) est recouvert d'un corps diélectrique doux (109, $\varepsilon_1$) adoucissant les ondulations potentielles (107) présentes sur ledit support d'informations (108).

FIG.1

FIG.2

FIG. 3

FIG. 4

FIG. 5

FIG.6

12

## FIG. 7

## FIG. 8